# EUROPEAN PATENT APPLICATION

(11) **EP 1 887 848 A2**
(43) Date of publication of application: **13.02.2008**
(21) Application number: 07113846.5
(22) Date of filing: 06.08.2007
(51) Int. Cl.: H05K 9/00

(54) **Methods and apparatus for installing a feed through filter**

(30) Priority: 10.08.2006 US 502076
(71) Applicant: HONEYWELL INC., Morristown, New Jersey 07962 (US)
(72) Inventor: Harrington, James B., Seminole, FL 33772 (US)
(74) Representative: Haley, Stephen

(57) **Abstract**

A method of installing a filter (100) into an electronic circuit board (102) is provided. The method includes inserting a second section (106) of the filter into an aperture (112) defined in the electronic circuit board, such that a first section (104) of the filter is secure against an electronic circuit board first surface (114) and a first lead (130) of the filter extends to a solder pad (134) on the electronic circuit board first surface. The method also includes coupling a second lead (122) to a second contact (118) of the filter such that the second lead extends to a solder pad (124) on an electronic circuit board second surface (120). The method also includes reflowing the circuit board such that the first lead is soldered to the electronic circuit board first surface, and the second lead is soldered to the electronic circuit board second surface.

## Description

This invention relates generally to electromagnetic interference (EMI) filters, and more particularly, to methods and apparatus for installing a feed through EMI filter.

There are many sources of EMI, and at least some of this EMI has a propensity to affect operation of many electronic systems. Specifically, operation of an electronic system at a specific frequency may be adversely affected or interfered with by signals at one or more different frequencies. The signals at the different frequencies can be both naturally occurring and man-made. Natural sources of EMI may include lightning, cosmic radiation, and strong winds. Man-made sources may include electronic equipment, lighting, radar transmitters, computer devices, and motors. As such, it is necessary to protect most of today's electronic systems from sources of EMI. One approach is to place a filter within the signal path of the electronic system to facilitate removing the EMI. Specifically, the filter operates as a shunt to ground for any signal within the signal path that contains frequencies outside of the operating frequency range of the electronic system.

One known type of EMI filter is a feed through filter. The feed through filter is configured to be inserted through a printed circuit board (PCB) such that a portion of the filter is maintained on both sides of the PCB. One function of the filter is to receive and ground frequencies outside of the circuit operating frequency range. Another function of the filter is to pass the low frequency signals within the signal path such that the signals continue through the circuit.

To install one embodiment of a feed through filter, the filter must be either press-fit into the PCB or retained within the PCB via a tightened nut. Wires are then soldered to leads at either end of the filter. Each wire is subsequently soldered to the PCB. Such a method of installing a feed through filter is reasonable when other components for the electronic circuit are also being manually soldered to the PCB, however, this method is undesirable when using automated pick and place systems to surface mount the other electronic components. During surface mounting, components are pressed into solder paste on signal pads on the surface of the PCB such that the electrical contacts of the components extend over signal pads on the PCB. When all the components are in place, the PCB undergoes a reflow process wherein the circuit board is heated to the point that the contacts of the electronic components are soldered to the signal pad to make a connection. Current feed through filter designs do not allow a filter to be soldered to signal pads of a PCB during a reflow process.

In one aspect, a method of installing a filter into an electronic circuit board is provided, wherein the filter includes a first section having a first contact and a first width and a second section having a second contact and a second width that is narrower than the first width. The filter also includes a first lead extending from the first contact and a second lead. The method includes inserting the second section into an aperture defined in the electronic circuit board, such that the first section is secure against an electronic circuit board first surface and the first lead extends to a solder pad on the electronic circuit board first surface. The method also includes coupling the second lead to the second contact such that the second lead extends to a solder pad on an electronic circuit board second surface. The method also includes reflowing the circuit board such that the first lead is soldered to the electronic circuit board first surface, and the second lead is soldered to the electronic circuit board second surface.

In another aspect, a filter configured for installation on an electronic circuit board is provided, wherein the filter includes a first section having a first contact and a first width, and a second section having a second contact and a second width that is narrower than the first width. The second section is configured to be inserted into an aperture in the electronic circuit board. The filter also includes a first lead extending from the first contact and configured to extend to a solder pad on a first surface of the electronic circuit board, and a second lead configured to couple to the second contact and extend to a solder pad on a second surface of the electronic circuit board, wherein contact between the solder pads and the first and the second lead enables the electronic circuit board to be reflowed.

In a further aspect, an electronic system configured to be reflowed is provided, wherein the electronic system includes an electronic circuit board having a first surface and a second surface, and at least one EMI filter. Each EMI filter includes a first section having a first contact and a first width, and a second section having a second contact and a second width that is narrower than the first width. The second section is inserted into the electronic circuit board such that the first section is secure against the electronic circuit board first surface. Each EMI filter also includes a first lead extending from the first contact to a solder pad on a said electronic board first surface, and a second lead coupled to the second contact and extending to a solder pad on the electronic circuit board second surface, wherein contact between the solder pads and the first and the second leads enables the electronic system to be reflowed.

In yet another aspect, a lead for a feed through filter is provided, wherein the lead includes an attachment member configured to engage a contact of the feed through filter and an elongated member extending from the body and configured to contact a solder pad of an electronic circuit board such that the electronic circuit board can be reflowed.

### IN THE DRAWINGS

Figure 1 is an electrical schematic of a known EMI filter.

Figure 2 is a schematic cross-sectional view of a prior art feed through filter inserted into an electronic circuit board.

Figure 3 is a schematic cross-sectional view of one embodiment of a feed through filter inserted into an electronic circuit board.

Figure 4 is a schematic cross-sectional view of an alternative embodiment of a feed through filter inserted into an electronic circuit board.

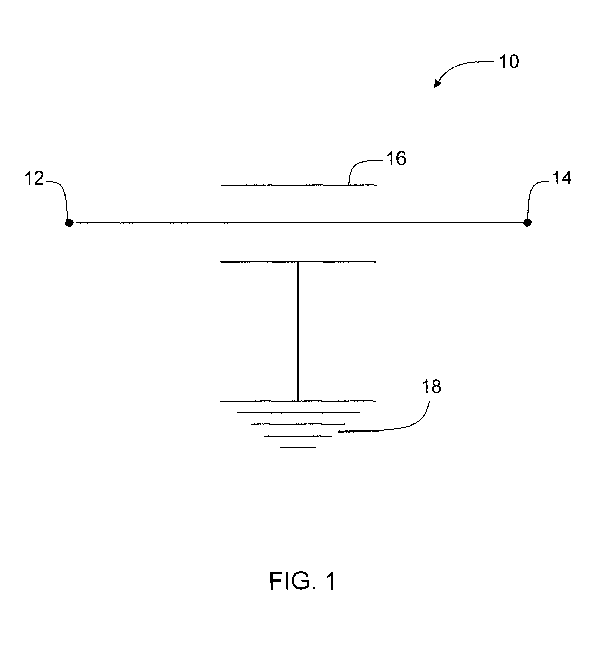

Figure 1 is an electrical schematic of a known EMI filter 10. Filter 10 includes a pair of leads 12 and 14 providing a signal path through filter 10. An inductor 16 is positioned within the signal path and a ground 18 is capacitively coupled to inductor 16. During operation, an electrical signal flows between leads 12 and 14. As the signal flows through inductor 16, high frequency components of the signal are removed and routed to ground 18 via the capacitive coupling. As such, only low frequency components are allowed to continue through the signal path.

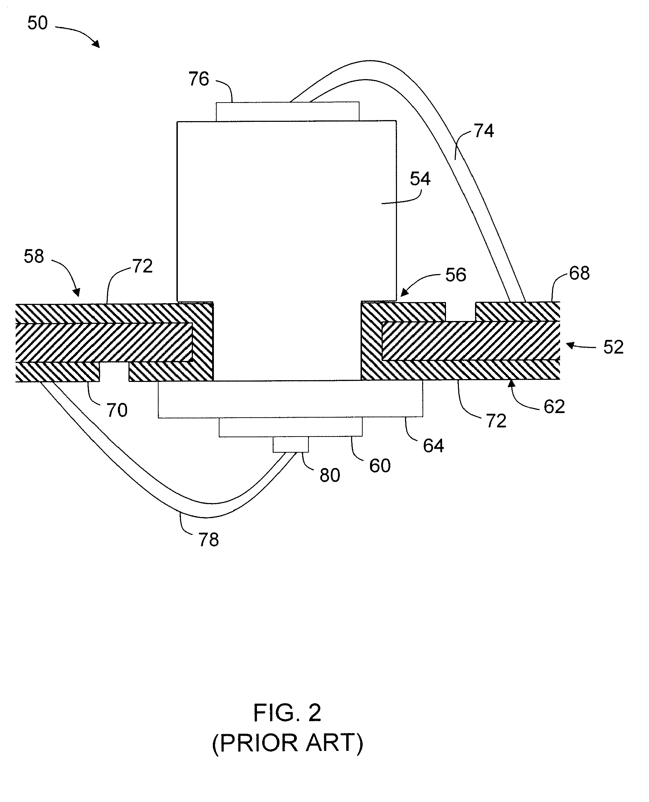

Figure 2 is a schematic cross-sectional view of a prior art feed through filter 50 inserted into a circuit board 52. Filter 50 includes a first section 54 having a width greater than the width of an aperture 56 formed within circuit board 52. Filter 50 extends through aperture 56 such that first section 54 is secure against a circuit board first surface 58. A second section 60 of filter 50 extends through circuit board 52 and past a circuit board second surface 62. In the illustrated embodiment, second section 60 is threaded to facilitate receiving a nut 64. Nut 64 is screwed onto second section 60 until nut 64 is secure against circuit board second surface 62. As such, filter 50 is secured to circuit board 52.

Circuit board 52 includes a first surface signal pad 68, a second surface signal pad 70, and a ground plane 72. Signal pads 68 and 70 form a portion of a signal path within circuit board 52. Filter 50 is configured to filter the signal traveling, for example, from signal pad 68 to signal pad 70 by providing a low resistance to a high frequency signal (e.g. EMI), which is routed to ground plane 72. Filter 50 is coupled to both first surface signal pad 68 and second surface signal pad 70. Specifically, a first wire 74 extends from a first contact 76 on first section 54 to first surface signal pad 68, and a second wire 78 extends from a second contact 80 on second section 60 to second surface signal pad 70.

To install filter 50 into circuit board 52, second section 60 is first inserted into aperture 56 until first section 54 is secure against circuit board first surface 58. Nut 64 is then tightened onto second section 60 until filter 50 is secured within circuit board 52. Wire 74 is then soldered to contact 76 and first surface signal pad 68, and wire 78 is soldered to contact 80 and second surface signal pad 70. The process of tightening nut 64 and soldering wires 74 and 78 is both time consuming and costly. Moreover, the process is incompatible with using an automated pick and place machine because wires 74 and 78 must be manually soldered to signal pads 68 and 70.

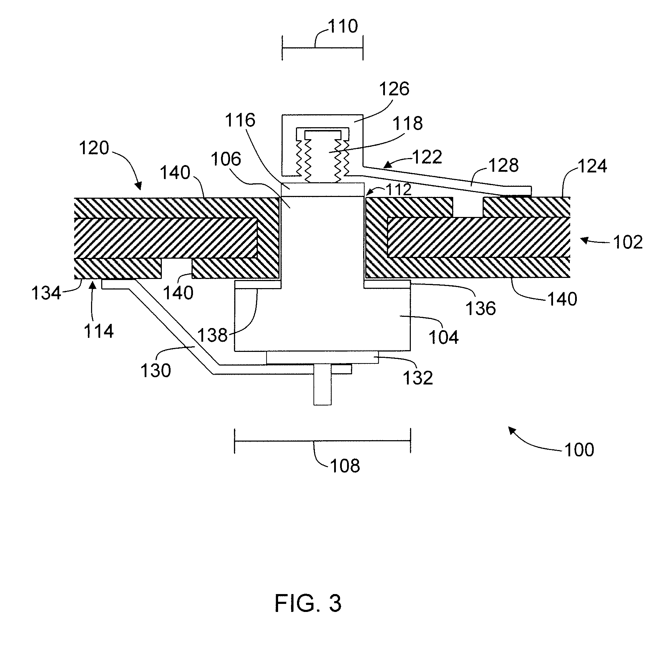

Figure 3 is a schematic cross-sectional view of one embodiment of a feed through filter 100 inserted into an electronic circuit board 102. Filter 100 includes a first section 104 and a second section 106. First section 104 has a width 108 that is wider than a second section width 110. Second section 106 extends through a circuit board aperture 112 such that first section 104 is secure against circuit board first surface 114. An insulator 116 is coupled to second section 106.

A second section contact 118 extends from insulator 116 and past circuit board second surface 120. A second section lead 122 is engaged with second section contact 118 and extends to a second surface signal pad 124 positioned on electronic circuit board second surface 120. Specifically, second section lead 122 includes an attachment member 126 and an elongated member 128. Attachment member 126 engages second section contact 118 and elongated member 128 extends to second surface signal pad 124. As such, second section lead 122 provides an electrical connection between filter 100 and electronic circuit board 102.

In the illustrated embodiment, second section contact 118 and second section lead attachment member 126 include corresponding protrusions configured to interlock such that second section lead 122 is secured to second section contact 118. In an alternative embodiment, second section contact 118 and attachment member 126 may include another mechanism capable of securing second section lead 122 to second section contact 118, such as friction. Furthermore, in one embodiment, attachment member 126 has a tubular shape configured to engage a cylindrical shape of second section contact 118. In other embodiments, attachment member 126 and second section contact 118 may include different corresponding shapes.

A first section lead 130 extends from a first section contact 132 and makes contact with a first surface signal pad 134 positioned on circuit board first surface 114. The contact between leads 122 and 130 and signal pads 124 and 134, respectively, allow for reflow of electronic circuit board 102. Moreover, the contact between leads 122 and 130 and signal pads 124 and 134, respectively, allows for an electrical signal flow from signal pad 134, through filter 100, to signal pad 124.

Both first section lead 130 and second section lead 122 are fabricated from any conductive material capable of being soldered during a circuit board assembly reflow process. Furthermore, both leads 130 and 122 are fabricated to have a spring-like quality. As such, the spring force in both leads 130 and 122 maintains a connection between leads 130 and 122 and signal pads 134 and 124, respectively. Furthermore, the spring force of second section lead 122 is configured to retain filter 100 within electronic circuit board 102 such that filter first section 104 is maintained securely against electronic circuit board 102.

In the illustrated embodiment first section 104 also includes a plating 136 applied to a ground contact 138 of first section 104. Plating 136 is any material capable of being soldered during a circuit board assembly reflow process. Filter 100 is positioned within circuit board 102 such that plating 136 is secure against a ground plane 140 located on circuit board first surface 114. Specifically, ground plane 140 extends 360 degrees around aperture 112, such that plating 136 facilitates sealing ground contact 138 and ground plane 140 to create a 360 degree seal around filter 100. In further embodiments, filter 100 is fabricated from a material capable of being soldered and, therefore, does not require plating 136 to seal ground contact 138 to ground plane 140.

In one embodiment, first section lead 130 is soldered to first section contact 132 prior to installation of filter 100. During installation, filter second section 106 is inserted through aperture 112 until ground contact 138 is secure against ground plane 140. In this position, first section lead 130 extends to and makes contact with first surface signal pad 134. First section lead 130 is retained in this position in a state of compression. Insulator 116 is positioned substantially level with circuit board second surface 120, and second section contact 118 extends past circuit board second surface 120. Second section lead 122 is positioned on second section contact 118. Second section lead 122 extends to and makes contact with second surface signal pad 124. Second section lead 122 is retained in this position in a state of compression. The spring force acting on leads 122 and 130 retains filter 100 within circuit board 102 while circuit board 102 is populated with other components with a pick and place assembly machine.

After the assembly process, circuit board 102 is subjected to a reflow process. During the reflow process, filter 100 is soldered to circuit board 102. Specifically, leads 122 and 130 and signal pads 124 and 134 may include solder pads that melt and cool during the reflow process or solder may be applied to leads 122 and 130 and signal pads 124 and 134 during reflow. The contact between leads 122 and 130 and signal pads 124 and 134, respectively, facilitate creating a bond when the solder pads cool. The bonds between leads 122 and 130 and signal pads 124 and 134, respectively, retain filter 100 within circuit board 102 and facilitate providing a signal path through filter 100 from signal pad 134 to signal pad 124. In the illustrated embodiment, plating 136 also melts and cools to solder a bond between ground contact 138 and ground plane 140. In an alternative embodiment, ground contact 138 is secured to ground plane 140 by the spring-like quality of lead 122.

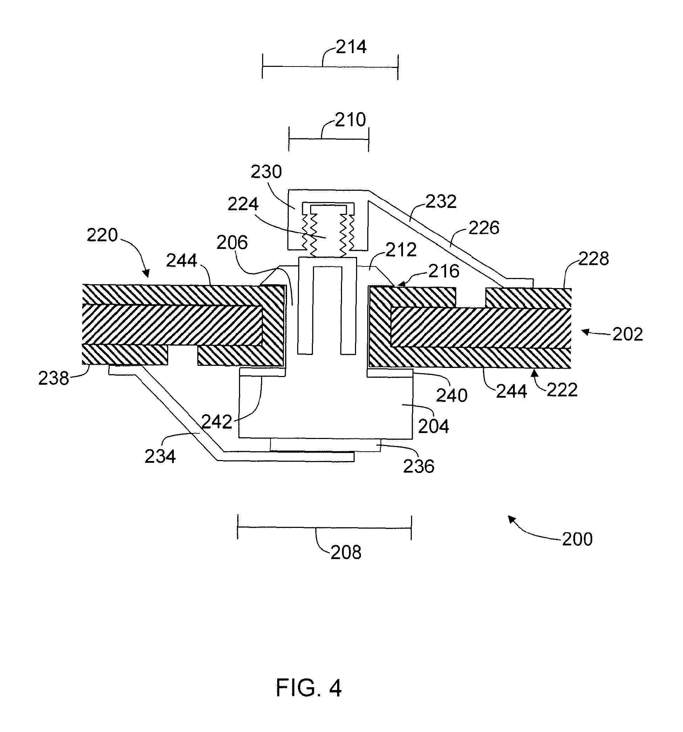

Figure 4 is a schematic cross-sectional view of an alternative embodiment of a feed through filter 200 inserted into an electronic circuit board 202. Filter 200 includes a first section 204 and a second section 206. First section 204 has a width 208 that is wider than a second section width 210. Second section 206 includes a protrusion 212 extending therefrom and having a width 214 that is wider than a width of a circuit board aperture 216. Furthermore, protrusion 212 is compressible such that second section 206 can be inserted through aperture 216. Second section 206 extends through circuit board aperture 216 such that protrusion 212 exits aperture 216 and extends partially across a circuit board second surface 220 to create a lock between filter 200 and circuit board 202. In this position, first section 204 is secure against a circuit board first surface 222.

A second section contact 224 extends from second section 206. A second section lead 226 is engaged with second section contact 224 and extends to a circuit board second surface signal pad 228. Specifically, second section lead 226 includes an attachment member 230 and an elongated member 232. Attachment member 230 engages second section contact 224 and elongated member 232 extends to second surface signal pad 228. As such, second section lead 226 provides an electrical connection between filter 200 and electronic circuit board 202.

In the illustrated embodiment, second section contact 224 and second section lead attachment member 230 include corresponding protrusions configured to interlock such that second section lead 226 is secured to second section contact 224. In an alternative embodiment, second section contact 224 and attachment member 230 may include another mechanism capable of securing second section lead 226 to second section contact 224, such as friction. Furthermore, in one embodiment, attachment member 230 has a tubular shape configured to engage a cylindrical shape of second section contact 224. In other embodiments, attachment member 230 and second section contact 224 may include different corresponding shapes.

A first section lead 234 extends from a first section contact 236 and contacts a first surface signal pad 238 positioned on circuit board first surface 222. The contact between leads 226 and 234 and signal pads 228 and 238, respectively, allow for reflow of electronic circuit board 202. Moreover, the contact between leads 226 and 234 and signal pads 228 and 238, respectively, allows for an electrical signal flow from signal pad 238, through filter 200, to signal pad 228.

Both first section lead 234 and second section lead 226 are fabricated from any conductive material capable of being soldered during a circuit board assembly reflow process. Furthermore, both leads 234 and 226 are fabricated to have a spring-like quality. As such, the spring force in both leads 234 and 226 maintains a connection between leads 234 and 226 and signal pads 238 and 228, respectively.

In the illustrated embodiment first section 204 also includes a plating 240 applied to a ground contact 242 of first section 204. Plating 240 is any material capable of being soldered during a circuit board assembly reflow process. Filter 200 is positioned within circuit board 202 such that plating 240 is secure against a ground plane 244 located on circuit board first surface 222. Specifically, ground plane 244 extends 360 degrees around aperture 216, such that plating 240 facilitates sealing ground contact 242 and ground plane 244 to create a 360 degree seal around filter 200. In further embodiments, filter 200 is fabricated from a material capable of being soldered and, therefore, does not require plating 240 to seal ground contact 242 to ground plane 244.

In one embodiment, first section lead 234 is soldered to first section contact 236 prior to installation of filter 200. During installation, filter second section 206 is inserted through aperture 216 until protrusion 212 exits through aperture 216 and extends across circuit board second surface 220. As such, protrusion 212 facilitates retaining filter 200 within circuit board 202 during assembly of circuit board 202 in a pick and place machine. In this position, first section lead 234 extends to and makes contact with first surface signal pad 238. Second section lead 226 is secured to second section contact 224. Second section lead 226 extends to and makes contact with second surface signal pad 228. Furthermore, filter 200 is positioned such that ground contact 242 is secure against ground plane 244.

Circuit board 202 is populated with other components in a pick and place machine and is then subjected to a reflow process. During the reflow process, filter 200 is soldered to circuit board 202. Specifically, leads 226 and 234 and signal pads 228 and 238 may include solder pads that melt and cool during the reflow process or solder may be applied to leads 226 and 234 and signal pads 228 and 238 during reflow. The contact between leads 226 and 234 and signal pads 228 and 238, respectively, facilitate creating a bond when the solder pads cool. The bond between leads 226 and 234 and signal pads 228 and 238, respectively, retain filter 200 within circuit board 202 and facilitate providing a signal path through filter 200 from signal pad 238 to signal pad 228. In the illustrated embodiment, plating 240 also melts and cools to solder a bond between ground contact 242 and ground plane 244. In an alternative embodiment, ground contact 242 is secured to ground plane 244 when protrusion 212 locks filter 200 within circuit board 202.

In one embodiment, a method of installing a filter into an electronic circuit board is provided, wherein the filter includes a first section having a first contact and a first width and a second section having a second contact and a second width that is narrower than the first width. The filter also includes a first lead extending from the first contact and a second lead. The method includes inserting the second section into an aperture defined in the electronic circuit board, such that the first section is secure against an electronic circuit board first surface and the first lead extends to a solder pad on the electronic circuit board first surface. The method also includes coupling the second lead to the second contact such that the second lead extends to a solder pad on an electronic circuit board second surface. The method also includes reflowing the circuit board such that the first lead is soldered to the electronic circuit board first surface, and the second lead is soldered to the electronic circuit board second surface.

The above-described apparatus and methods provide a feed through filter capable of being used with a pick and place machine and a reflow process, while maintaining a quality electronic connection between the filter and a circuit board. Specifically, the filter can be inserted into the circuit board prior to the pick and place process. The spring force of the leads facilitates retaining the filter in position until and during the reflow process. Furthermore, the contact between the leads and the signal pad eliminate the need for leads from a filter to be manually soldered to the circuit board.

As used herein, an element or step recited in the singular and proceeded with the word "a" or "an" should be understood as not excluding plural said elements or steps, unless such exclusion is explicitly recited. Furthermore, references to "one embodiment" of the present invention are not intended to be interpreted as excluding the existence of additional embodiments that also incorporate the recited features.

Although apparatus and methods described herein are described in the context of feed through filters for a circuit board, it is understood that the apparatus and methods are not limited to feed through filters or circuit boards. Likewise, the feed through filter components illustrated are not limited to the specific embodiments described herein, but rather, components of the feed through filter can be utilized independently and separately from other components described herein.

While the invention has been described in terms of various specific embodiments, those skilled in the art will recognize that the invention can be practiced with modification within the spirit and scope of the claims.

## Claims

1. A filter (100) configured for installation on an electronic circuit board (102), said filter comprising:
a first section (104) having a first contact (132) and a first width (108);
a second section (106) having a second contact (118) and a second width (110) that is narrower than said first width, said second section configured to be inserted into an aperture (112) in the electronic circuit board;
a first lead (130) extending from said first contact and configured to extend to a solder pad (134) on a first surface (114) of the electronic circuit board; and
a second lead (122) configured to couple to said second contact and extend to a solder pad (124) on a second surface (120) of the electronic circuit board, wherein contact between the solder pads and said first and said second lead enables the electronic circuit board to be reflowed.

2. A filter (100) in accordance with Claim 1 wherein said first and said second leads (130, 122) have a spring-like quality which enables said first and said second lead to contact the solder pads (134, 124) on the electronic circuit board (102).

3. A filter (100) in accordance with Claim 2 wherein said spring-like quality of said second lead (122) is configured to retain said filter within the electronic circuit board (102).

4. A filter (100) in accordance with Claim 1 wherein said second section contact (118) extends from said second section (106) and said second lead (122) is configured to engage said second section contact.

5. A filter (100) in accordance with Claim 4 wherein the second section contact (118) and the second lead (122) both comprise a plurality of protrusions (212), said second lead plurality of protrusions configured to interlock with said second section contact plurality of protrusions.

6. A filter (100) in accordance with Claim 1 wherein said first section (106) comprises a plating (136) configured to solder said first section to a ground plane (140) of the electronic circuit board (102).

7. A filter (100) in accordance with Claim 1 wherein said second section (106) comprises a protrusion (212) extending therefrom and configured to lock said filter in the electronic circuit board (102).
